**Europäisches Patentamt**

**European Patent Office**

**Office européen des brevets**

(11) Veröffentlichungsnummer: **0 155 370 B1**

(12) # EUROPÄISCHE PATENTSCHRIFT

(45) Veröffentlichungstag der Patentschrift: **02.01.92**

(51) Int. Cl.⁵: **G06F 12/00**

(21) Anmeldenummer: **84114786.1**

(22) Anmeldetag: **05.12.84**

(54) **Schaltung zur Adressierung eines Speichers.**

(30) Priorität: **16.03.84 DE 3409751**

(43) Veröffentlichungstag der Anmeldung:
**25.09.85 Patentblatt 85/39**

(45) Bekanntmachung des Hinweises auf die
Patenterteilung:
**02.01.92 Patentblatt 92/01**

(84) Benannte Vertragsstaaten:
**AT BE DE FR GB IT NL**

(56) Entgegenhaltungen:
**EP-A- 0 054 490**
**WO-A-79/00035**
**US-A- 3 564 505**
**US-A- 3 962 689**

(73) Patentinhaber: **SIEMENS AKTIENGESELL-
SCHAFT**
**Wittelsbacherplatz 2**
**W-8000 München 2(DE)**

(72) Erfinder: **Alois, Rainer, Dipl.**
**Millevistrasse 52/11**
**A-9500 Villach(AT)**
Erfinder: **Ulbrich, Walter, Dr.**
**Renkenstrasse 36**
**D-8031 Pucheim(DE)**

EP 0 155 370 B1

**Beschreibung**

Die Erfindung bezieht sich auf eine Schaltung zur Adressierung eines Speichers über ein Adressenregister.

Aus der EP-A-0 054 490 ist eine Möglichkeit zur zyklischen Adressierung eines Pufferspeichers (Ringpuffer) bei einer Einrichtung zum Informationsaustausch von Systemen mit unterschiedlicher Verarbeitungsgeschwindigkeit bekannt. Die US-PS 3,564,505 zeigt eine Möglichkeit zum wahlweisen Zuführen unterschiedlicher Adressen zu einem Adreßregister mit Hilfe eines Multiplexers bei einem digitalen Datenumordnungssystem.

Es liegt der Erfindung die Aufgabe zugrunde, eine Mehrzahl von Speicherplätzen, die durch eine Mehrzahl von innerhalb eines frei wählbaren Adressenbereiches liegenden Binäradressen gekennzeichnet sind, zyklisch zu adressieren. Hierunter soll z.B. verstanden werden, daß die Schaltung eine Folge von Adressen bildet, die, insbesondere ausgehend von einer Adressenbereichsuntergrenze, den Adressenbereich in einzelnen Schritten in aufsteigender Richtung durchläuft, wobei jeweils nach dem Erreichen einer Adressenbereichsobergrenze auf die Adressenbereichsuntergrenze umgeschaltet und eine weitere, den Adressenbereich schrittweise in aufsteigender Richtung durchlaufende Adressenfolge abgegeben wird. Andererseits kann eine zyklische Adressierung auch so verstanden werden, daß die Schaltung eine Folge von Adressen bildet, die, insbesondere ausgehend von einer Adressenbereichsobergrenze, den Adressenbereich schrittweise in absteigender Richtung durchläuft, wobei jeweils nach dem Erreichen der Adressenbereichsuntergrenze auf die Adressenbereichsobergrenze umgeschaltet und mit einer weiteren, den Adressenbereich in absteigender Richtung durchlaufenden Adressenfolge fortgesetzt wird.

Diese Aufgabe wird erfindungsgemäß durch eine Ausbildung der Schaltung gemäß den kennzeichnenden Merkmalen der Ansprüche 1 oder 2 gelöst.

Der mit der Erfindung erzielbare Vorteil liegt insbesondere darin, daß durch die zyklische Speicheradressierung die in einer Mehrzahl von Speicherplätzen abgelegten Daten in einfacher Weise periodisch abgefragt und mit anderen Daten verarbeitet oder verglichen werden können, wobei die Grenzen des Adressenbereichs und damit die Grenzen des abgefragten Speicherbereichs beliebig festlegbar sind. Die zyklische Speicheradressierung erlaubt es, in besonders vorteilhafter Weise eine Signalverarbeitung (signal processing) durchzuführen, wobei die in den periodisch abgefragten Speicherplätzen gespeicherten Daten den nacheinander abgetasteten Funktionswerten eines zu verarbeitenden zeitabhängigen Signals entsprechen. Dabei gelingt es, mit einem Minimum an Umspeichervorgängen eine vorgegebene Anzahl von solchen Abtastwerten zu speichern und den Bestand der gespeicherten Abtastwerte durch jeden neuen Abtastwert in der Weise zu verändern, daß dieser an die Stelle des jeweils ältesten gespeicherten Abtastwertes tritt. Das bedeutet, daß der gespeicherte Bestand an Abtastwerten schrittweise aktualisiert wird. Durch eine zyklische Speicheradressierung kann der gespeicherte, jeweils aktualisierte Datenbestand auch in sehr einfacher Weise zur weiteren Verarbeitung ausgelesen werden.

Die Ansprüche 3 bis 5 sind auf bevorzugte Ausgestaltungen und Weiterbildungen der Erfindung gerichtet.

Die Erfindung wird nachfolgend anhand der Zeichnung näher erläutert. Dabei zeigt:

Fig. 1    das Prinzipschaltbild einer Datenverarbeitungsanlage, die eine Schaltung nach der Erfindung enthält,

Fig. 2    eine Teilschaltung von Fig. 1. und

Fig. 3    Diagramme zur Erläuterung eines Betriebsverfahrens für eine Schaltung nach Fig. 1.

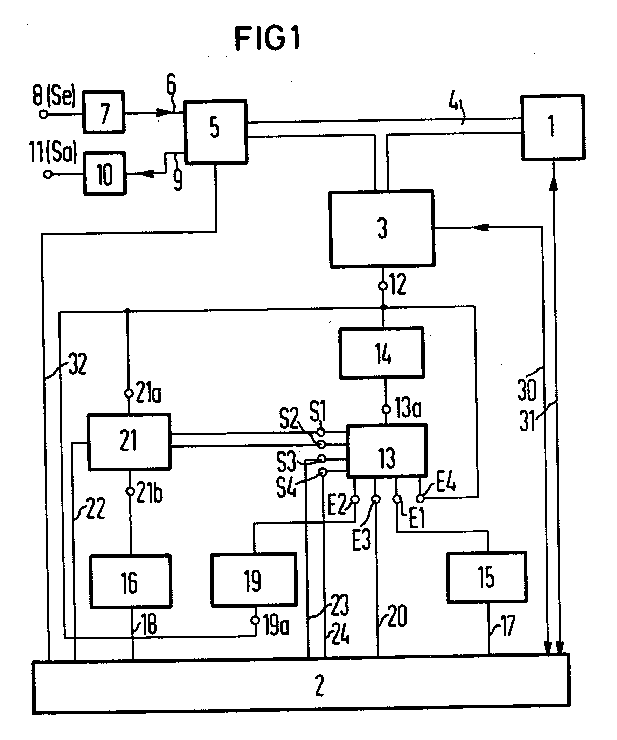

In Fig. 1 ist eine Datenverarbeitungsanlage mit einem Rechenwerk 1, einem Leitwerk 2 und einem Speicher mit wahlfreiem Zugriff (RAM) 3 dargestellt. Das Rechenwerk 1 ist über eine Sammelleitung 4 mit dem Speicher 3 sowie mit einer Eingabe/Ausgabe-Einheit 5 verbunden, deren Eingang über eine n-adrige Leitung 6 mit einem Analog/Digital-Wandler 7 beschaltet ist. Dessen Eingang 8 ist mit einem zu verarbeitenden zeitabhängigen analogen Signal Se belegt. Ein Ausgang von 5 ist über eine n-adrige Leitung 9 mit einem Digital/Analog-Wandler 10 verbunden, an dessen Ausgang 11 ein analoges Signal Sa abgreifbar ist.

Mit 13 ist ein Adressen-Multiplexer bezeichnet, dessen Ausgang 13a mit einem Adressenregister 14 beschaltet ist. Der Ausgang von 14 ist an den Adresseneingang 12 des Speichers 3 gelegt. Weiterhin sind ein Register 15 zur Speicherung einer Adressenbereichsuntergrenze und ein Register 16 zur Speicherung einer Adressenbereichsobergrenze vorgesehen, deren Eingänge jeweils über Leitungsbündel 17 und 18 mit dem Leitwerk 2 verbunden sind. Eine Inkrementiereinrichtung 19 ist über ihren Eingang 19a mit dem Ausgang des Adressenregisters 14 verbunden. Die Ausgänge des Registers 15 und der Inkrementiereinrichtung 19 sind an die Eingänge E1 und E2 des Adressen-Multiplexers 13 geschaltet. Eine n-adrige Adresseneingabeleitung 20 verbindet das Leitwerk 2 mit dem Eingang E3 von 13. Außerdem ist der Ausgang des Adressenregisters 14 mit dem Eingang E4 von 13 verbunden. Die Ausgänge des Adressenregisters 14 und des Registers 16 sind an Eingänge 21a und 21b einer Logikschaltung 21 gelegt, die vom Leitwerk 2 über die Leitung 22 angesteuert wird. Zwei Ausgänge der Logikschaltung 21 sind mit zwei Steuereingängen S1 und S2 des Adressen-Multiplexers 13 verbunden, während zwei weitere Steuereingänge S3 und S4 von 13 über Leitungen 23 und 24 mit dem Leitwerk 2 verbunden sind. Durch Zuführung eines Steuersignals an S1 wird der Eingang E1 an den Ausgang 13a von 13 durchgeschaltet. Analog hierzu wird jeder der Eingänge E2, E3 oder E4 durch ein Steuersignal an S2, S3 oder S4 auf den Ausgang 13a durchgeschaltet. Die Logikschaltung 21 arbeitet in der Weise, daß bei Gleichheit der Inhalte des Adressenregisters 14 und des Registers 16 in Abhängigkeit von einem Befehlssignal auf der Leitung 22 ein Steuersignal über den einen Ausgang auf S1 übertragen wird. Bei Ungleichheit dieser Registerinhalte wird in Abhängigkeit von einem Befehlssignal auf der Leitung 22 ein Steuersignal über den anderen Ausgang auf S2 übertragen.

Zur Festlegung des zu adressierenden Speicherbereichs wird dem Register 15 über das Leitungsbündel 17 eine n-stellige Binärzahl eingegeben, die die Adressenbereichsuntergrenze darstellt. Dem Register 16 wird über das Leitungsbündel 18 eine andere n-stellige Binärzahl eingegeben, die die Adressenbereichsobergrenze bedeutet. Gibt man nun über die Adresseneingabeleitung 20 eine zwischen diesen beiden Binärzahlen liegende, weitere n-stellige Binärzahl ein, und schaltet diese durch ein Befehlssignal auf der Leitung 23 über E3 auf den Ausgang 13a des Adressen-Multiplexers 13 durch, so wird diese Binärzahl auf das Adressenregister 14 übertragen. Damit wird über den Ausgang von 14 an den Adresseneingang 12 eine Adresse abgegeben, die innerhalb des eingestellten Adressenbereichs liegt.

Für eine fortlaufende zyklische Adressierung innerhalb dieses Speicherbereichs in aufsteigender Richtung, genügt es, der Logikschaltung 21 über die Leitung 22 eine Reihe von Befehlssignalen zuzuführen. Jedes derselben veranlaßt die Logikschaltung 21 unter der Voraussetzung, daß die jeweils von 14 abgegebene Adresse innerhalb des Adressenbereichs liegt, zur Abgabe eines Steuersignals an den Eingang S2. Da von der jeweils abgegebenen Adresse, die auch am Eingang 19 der Inkrementiereinrichtung 19 anliegt, in 19 automatisch die nächsthöhere Adresse abgeleitet und an den Eingang E2 gelegt wird, bedeutet das Eintreffen eines Steuersignals am Eingang S2, daß die nächsthöhere Adresse über 13 und 13a an den Ausgang von 14 durchgeschaltet wird. Wird von 14 eine Adresse abgegeben, die der Bereichsobergrenze entspricht, so ergeben sich die gleichen Registerinhalte in den Registern 14 und 16. Damit wird durch das nächstfolgende Befehlssignal auf der Leitung 22 die Logikschaltung 21 zur Abgabe eines Signals an den Eingang S1 von 13 veranlaßt. Das bedeutet aber, daß die im Register 15 gespeicherte Adresse, die der Adressenbereichsuntergrenze entspricht, über E1, 13 und 14 an den Adresseneingang 12 des Speichers 3 gelangt. Die nächstfolgenden Befehlssignale auf der Leitung 22 veranlassen dann wieder die Abgabe einer Adressenfolge, die den Adressenbereich schrittweise in aufsteigender Richtung durchläuft.

Die Inkrementiereinrichtung 19 besteht zweckmäßigerweise aus einem Binärzähler, der automatisch bei Eingabe einer Binärzahl über den Eingang 19a eine um ein bestimmtes Inkrement, z.B. 1, erhöhte Binärzahl an den Eingang E2 des Adressen-Multiplexers 13 abgibt.

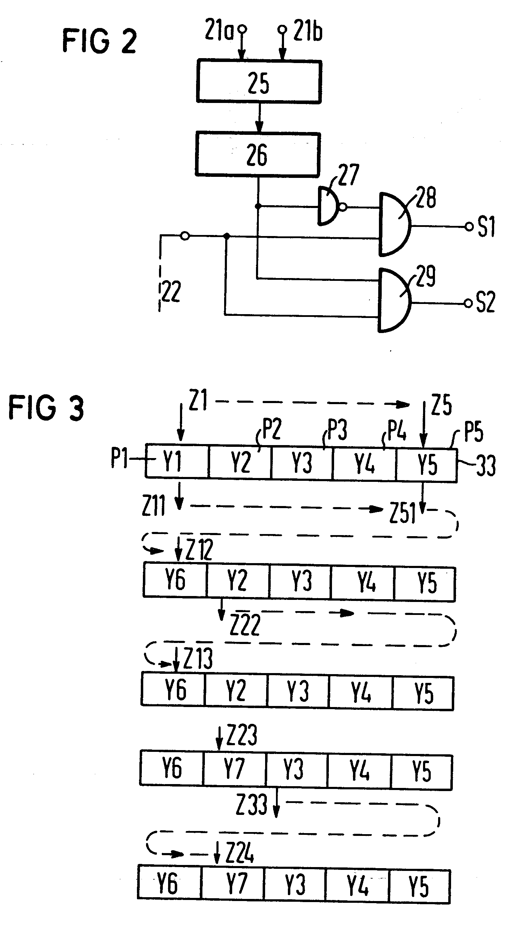

Eine bevorzugte schaltungstechnische Durchbildung der logischen Schaltung 21 ist in Fig. 2 gezeigt. Hierbei stellen die (n-poligen) Eingänge 21a und 21b von 21 gleichzeitig die Eingänge einer Exklusiv-ODER-Schaltung 25 dar, deren (n-poliger) Ausgang an die n Eingänge einer ODER-Schaltung 26 geführt ist. Der Ausgang der letzteren ist einerseits über einen Inverter 27 mit dem ersten Eingang eines UND-Gliedes 28 und andererseits mit dem ersten Eingang eines UND-Gliedes 29 direkt verbunden. Die zweiten Eingänge der UND-Glieder 28 und 29 sind mit der Steuerleitung 22 beschaltet. Der Ausgang des UND-Gliedes 28 ist an den Steuereingang S1 des Adressen-Multiplexers 13 geführt, während der Ausgang des UND-Gliedes 29 mit S2 von 13 verbunden ist. Am Ausgang der ODER-Schaltung 26 liegt immer dann eine logische "1", wenn die über 21a und 21b zugeführten n-stelligen Binärzahlen voneinander abweichen. Das bedeutet aber eine Sperrung des UND-Gliedes 28, während die auf der Leitung 18 ankommenden Befehlssignale über das UND-Glied 29 auf S2 übertragen werden und eine inkrementelle Weiterschaltung der jeweils ausgegebenen Adressen bewirken. Sind die Registerinhalte von 14 und 16 gleich, so werden über 21a und 21b gleiche Binärzahlen zugeführt. Am Ausgang von 26 erscheint in diesem Fall eine logische "0", wobei das UND-Glied 28 das nächstfolgende Befehlssignal auf der Leitung 22 an den Steuereingang von S1 überträgt, während das UND-Glied 29 sperrt.

Ersetzt man in Figur 1 die Inkrementiereinrichtung 19 durch eine Dekrementiereinrichtung, die beispielsweise aus einem Rückwärtszähler besteht, und verwendet gleichzeitig das Register 15 zur Speicherung der Adressenbereichsobergrenze und das Register 16 zur Speicherung der Adressenbereichsuntergrenze, so ergibt sich eine zyklische Adressierung, bei der der zwischen diesen Grenzen liegende Adressenbereich von den einzelnen Adressenfolgen in jeweils absteigender Richtung durchlaufen wird.

Über Steuerleitungen 30 werden dem Speicher 3 aus dem Leitwerk 2 Befehlssignale mitgeteilt, die ihn z.B. veranlassen, entweder eine über die Sammelleitung 4 empfangene Binärzahl in einen jeweils über das Adressenregister 14 adressierten Speicherplatz einzuschreiben oder eine Binärzahl, die in einem jeweils über das Adressenregister 14 adressierten Speicherplatz gespeichert ist, auf die Sammelleitung 4 auszulesen. Steuerleitungen 31 dienen zur Übermittlung von Befehlen, z.B. Operationsbefehlen, zwischen dem Leitwerk 2 und dem Rechenwerk 1, während Steuerleitungen 32 dazu benutzt werden, um in der Eingabe/Ausgabe-Einheit 5 die Leitung 6 in Richtung auf die Sammelleitung 4 oder die Sammelleitung 4 in Richtung auf die Leitung 9 durchzuschalten.

Nachfolgend wird ein Verfahren zum Betrieb der Datenverarbeitungsanlage nach Fig. 1 beschrieben, das eine zyklische Adressierung eines Bereiches des Speichers 3 verwendet, um Abtastwerte des an 8 liegenden, analogen, zeitabhängigen Signals Se zur Verarbeitung im Rechenwerk 1 bereitzustellen. Dabei wird das Signal Se von dem Analog/Digital-Wandler 7 periodisch abgetastet, wobei eine Folge von digitalen Abtastwerten gebildet wird, die jeweils aus n-stelligen Binärzahlen Y1, Y2 ... usw. bestehen. Eine vorgegebene Anzahl dieser Abtastwerte wird über die Eingabe/Ausgabe-Einheit 5 nacheinander auf die Sammelleitung 4 und von dort zum Speicher 3 übertragen, wo sie in eine entsprechende Anzahl von Speicherplätzen eingeschrieben werden. Letztere werden nacheinander über das Adressenregister 14 adressiert. Für fünf Abtastwerte Y1 ... Y5, die in den Speicher 3 eingeschrieben werden sollen, benötigt man fünf Speicherplätze P1 ... P5, von denen jeder n-stellig ausgebildet ist, also n Speicherzellen umfaßt.

In Fig. 3 sind die Speicherplätze P1 ... P5 durch einen entsprechend unterteilten Block 33 dargestellt. Eine Adressierung von P1 ... P5 synchron mit dem Auftreten der einzelnen Abtastwerte Y1 ... Y5 erfolgt durch eine von 14 abgegebene Adressenfolge mit den einzelnen Adressen Z1 ... Z5, die in Fig. 3 durch die Zeiger Z1 ... Z5 veranschaulicht sind. Durch einen gleichzeitigen Befehl "Einschreiben" auf den Leitungen, 30 wird der Abtastwert Y1 in P1 gespeichert, der Abtastwert Y2 in P2 usw.. Dabei wird die Adressenfolge Z1 bis Z5 zweckmäßigerweise so erzeugt, daß Z1 über die Adresseneingabeleitung 20 als Startadresse eingegeben und durch ein Signal auf der Leitung 23 an den Ausgang des Adressenregisters 14 durchgeschaltet wird. Es schließen sich vier Signale auf der Befehlsleitung 22 an, die jeweils eine Weiterschaltung von Z1 auf die weiteren Adressen Z2 bis Z5 bewirken. Durch Eingabe von Z1 über das Leitungsbündel 17 als Adressenbereichsuntergrenze und von Z5 über das Leitungsbündel 18 als Adressenbereichsobergrenze wurde vorher festgelegt, daß der Adressenbereich Z1 bis Z5 schrittweise zyklisch durchlaufen werden soll.

Es folgen nun mehrere derartige zyklische Adressendurchläufe, und zwar jeweils in aufsteigender Richtung. Für jeden derselben werden über die Leitung 22 fünf Befehlssignale übertragen. Dabei bewirken die ersten fünf dieser Signale, daß, ausgehend von der zuletzt ausgegebenen Adresse Z5, eine Adressenfolge Z11 bis Z51 gebildet wird. Während des Auftretens dieser Adressenfolge wird dem Speicher 3 über die Leitungen 30 der Befehl "Auslesen" mitgeteilt, so daß die in P1 ... P5 gespeicherten Abtastwerte Y1 ... Y5 auf die Sammelleitung 4 ausgelesen und dem Rechenwerk 1 zugeführt werden, in dem sie in herkömmlicher Weise verarbeitet werden. Durch das nächstfolgende Befehlssignal auf der Leitung 22 wird über das Adressenregister 14 die Adresse Z12 abgegeben, die der Adressenbereichsuntergrenze entspricht. Hiermit beginnt der zweite Adressendurchlauf. Die Leitungen 30 werden während der Abgabe dieser Adresse mit dem Befehl "Einschreiben" belegt, so daß der unter der Adresse Z1 gespeicherte Abtastwert Y1, der den ältesten der gespeicherten Abtastwerte darstellt, durch einen neuen Abtastwert Y6 ersetzt bzw. überschrieben wird. Beim Auftreten der übrigen Adressen Z22 bis Z52 innerhalb des zweiten Durchlaufes wird der Befehl "Auslesen" auf die Leitung 30 gegeben.

Während des dritten Durchlaufes, d.h. während der Abgabe der Adressen Z13 ... Z53, wird der Befehl "Einschreiben" auf den Leitungen 30 wieder nur während des Auftretens einer einzigen Adresse, und zwar der Adresse Z23, dem Speicher 3 mitgeteilt, während allen übrigen Adressen dieses Durchlaufes der Befehl "Auslesen" zugeordnet ist. Damit wird der in P2 gespeicherte Abtastwert Y2, der den ältesten noch verbliebenen Abtastwert unter den gespeicherten Abtastwerten darstellt, durch einen neuen Wert Y7 ersetzt. Die übrigen Speicherplätze, d.h. P1 bis P3 und P5, werden dagegen ausgelesen, wobei die ausgelesenen Abtastwerte dem Rechenwerk 1 zugeführt werden.

Bei jedem der folgenden Adressendurchläufe wird ebenfalls beim Erreichen eines einzigen Speicherplatzes ein neuer Abtastwert eingeschrieben, während die übrigen Speicherplätze ausgelesen werden. Betrachtet man die Adressen, die in den einzelnen Durchläufen jeweils einem Einschreibebefehl zugeordnet sind, so ergibt sich eine Folge Z12, Z23, Z34, Z45 und Z56, wobei die zugehörigen Speicherplätze in jedem Durchlauf um eine Stelle weiter gegenüber dem der Bereichsuntergrenze Z1 zugeordneten Speicherplatz P1 versetzt sind.

Andererseits werden in einer ersten Ausleseperiode die Abtastwerte Y1 bis Y5 ausgelesen, in einer zweiten Ausleseperiode die Werte Y2 ... Y6, in einer dritten Ausleseperiode die Abtastwerte Y3 ... Y7 usw., so daß jeweils ein von Ausleseperiode zu Ausleseperiode aktualisierter Bestand von Abtastwerten der weiteren Verarbeitung zugrunde gelegt wird. Die Ausgabe der Adressen Z1, Z2 ... Z5, Z12, Z23, Z34, Z45 und Z56 erfolgt dabei in gleichen zeitlichen Abständen.

Nach einer Verarbeitung der jeweils ausgelesenen Abtastwerte im Rechenwerk 1, die in an sich bekannter Weise erfolgt und nicht Gegenstand dieser Erfindung ist, werden die erhaltenen Ergebniswerte, die beispielsweise eine Filterung des zeitabhängigen Signals Se in einem Transversalfilter mit vorgegebenen Filterkoeffizienten berücksichtigen, über die Sammelleitung 4 und die entsprechend gesteuerte Eingabe/Ausgabe-Einheit 5 auf die Leitung 9 ausgegeben. Der Digital/Analog-Wandler 10 leitet aus den ankommenden digitalen Ergebniswerten Analogwerte ab, die in ihrer Gesamtheit, insbesondere nach einer weiteren Filterung in einem nachgeschalteten Tiefpaß, das analoge Ausgangssignal Sa darstellen.

**Patentansprüche**

1. Schaltung zur zyklischen Adressierung eines Speichers über ein Adressenregister (14), **dadurch gekennzeichnet,** daß das Adressenregister (14) einem Adressen-Multiplexer (13) nachgeschaltet ist, der Eingänge (E1, E2) aufweist, die mit einem zur Speicherung einer Adressenbereichsuntergrenze dienenden zweiten Register (15) und einer Inkrementiereinrichtung (19) beschaltet sind, wobei die Inkrementiereinrichtung (19) über ihren Eingang (19a) mit dem Ausgang des Adreßregisters (14) verbunden ist, daß Steuereingänge (S1, S2) des Adressen-Multiplexers (13) mit einer Logikschaltung (21) verbunden sind, daß die Logikschaltung (21) jeweils mit den Ausgängen des Adressenregisters (14) und eines zur Speicherung einer Adressenbereichsobergrenze dienenden dritten Registers (16) verbunden ist und daß die Logikschaltung (21) bei Gleichheit der Inhalte des Adressenregisters (14) und des dritten Registers (16) das zweite Register (15), bei Ungleichheit der genannten Inhalte die Inkrementiereinrichtung (19) an den Ausgang (13a) des Adressen-Multiplexers (13) durchschaltet.

2. Schaltung zur zyklischen Adressierung eines Speichers über ein Adressenregister (14), **dadurch gekennzeichnet,** daß das Adressenregister einem Adressen-Multiplexer (13) nachgeschaltet ist, der Eingänge (E1, E2) aufweist, die mit einem zur Speicherung einer Adressenbereichsobergrenze dienenden vierten Register und einer Dekrementiereinrichtung beschaltet sind, wobei die Dekrementiereinrichtung (19) über ihren Eingang (19a) mit dem Ausgang des Adreßregisters (14) verbunden ist, daß Steuereingänge (S1, S2) des Adressen-Multiplexers (13) mit einer Logikschaltung (21) verbunden sind, daß die Logikschaltung (21) jeweils mit den Ausgängen des Adressenregisters (14) und eines zur Speicherung einer Adressenbereichsuntergrenze dienenden fünften Registers verbunden ist und daß die Logikschaltung (21) bei Gleichheit der Inhalte des Adressenregisters (14) und des fünften Registers das vierte Register, bei Ungleichheit der genannten Inhalte die Dekrementiereinrichtung an den Ausgang (13a) des Adressen-Multiplexers (13) durchschaltet.

3. Schaltung nach Anspruch 1 oder 2, **dadurch gekennzeichnet,** daß der Ausgang des dritten oder fünften Registers und der Ausgang des Adressenregisters mit Eingängen einer in der Logikschaltung (21) enthaltenen Exklusiv-ODER-Schaltung (25) verbunden sind, deren Ausgang an den Eingängen einer ODER-Schaltung (26) liegt, daß der Ausgang der ODER-Schaltung (26) einerseits über einen Inverter (27) mit dem ersten Eingang eines ersten UND-Gliedes (28) und andererseits mit dem ersten Eingang eines zweiten UND-Gliedes (29) verbunden ist, daß die zweiten Eingänge beider UND-Glieder (28, 29) mit einer Ansteuerleitung (22) der Logikschaltung (21) verbunden sind und daß die Ausgänge der UND-Glieder (28, 29) jeweils an einen Steuereingang (S1, S2) des Adressen-Multiplexers (13) geführt sind.

4. Schaltung nach einem der Ansprüche 1 bis 3, **dadurch gekennzeichnet,** daß der Adressenregisterausgang an einen Eingang (E4) des Adressen-Multiplexers (13) geführt ist und daß der Adressen-Multiplexer (13) mit einem weiteren Steuereingang (S4) versehen ist, über den der Adressenregisterausgang auf den Ausgang (13a) des Adressen-Multiplexers (13) durchschaltbar ist.

5. Schaltung nach einem der Ansprüche 1 bis 4, **dadurch gekennzeichnet,** daß eine Adresseneingabeleitung (20) vorgesehen ist, die vom Leitwerk (2) an einen Eingang des Adressen-Multiplexers (13) geführt ist, und daß der Adressen-Multiplexer (13) mit einem zusätzlichen Steuereingang (S3) versehen ist, über den die Adresseneingabeleitung (20) auf den Ausgang (13a) des Adressen-Multiplexers (13) durchschaltbar ist.

## Claims

1. Circuit for cyclically addressing a memory via an address register (14), characterised in that the address register (14) is connected following an address multiplexer (13) having inputs (E1, E2), to which a second register (15) serving to store a lower limit of an address range and an incrementation means (19) are connected, the incrementation means (19) being connected via its input (19a) to the output of the address register (14), in that control inputs (S1, S2) of the address multiplexer (13) are connected to a logic circuit (21), in that the logic circuit (21) is connected in each case to the outputs of the address register (14) and of a third register (16) serving to store an upper limit of an address range, and in that if the contents of the address register (14) and of the third register (16) are identical the logic circuit (21) connects through the second register (15), and if the aforesaid contents are not identical connects through the incrementation means (19), to the output (13a) of the address multiplexer (13).

2. Circuit for cyclically addressing a memory via an address register (14), characterised in that the address register is connected following an address multiplexer (13) having inputs (E1, E2), to which a fourth register serving to store an upper limit of an address range and a decrementation means are connected, the decrementation means (19) being connected via its input (19a) to the output of the address register (14), in that control inputs (S1, S2) of the address multiplexer (13) are connected to a logic circuit (21), in that the logic circuit (21) is connected in each case to the outputs of the address register (14) and of a fifth register serving to store a lower limit of an address range, and in that if the contents of the address register (14) and of the fifth register are identical the logic circuit (21) connects through the fourth register, and if the aforesaid contents are not identical connects through the decrementation means, to the output (13a) of the address multiplexer (13).

3. Circuit according to Claim 1 or 2, characterised in that the output of the third or fifth register and the output of the address register are connected to inputs of an exclusive-OR circuit (25) contained in the logic circuit (21), the output of which exclusive-OR circuit is supplied to the inputs of an OR circuit (26), in that the output of the OR circuit (26) is connected on the one hand via an inverter (27) to the first input of a first AND gate (28) and on the other hand to the first input of a second AND gate (29), in that the second inputs of both AND gates (28, 29) are connected to a drive line (22) of the logic circuit (21), and in that the outputs of the AND gates (28, 29) are fed in each case to a control input (S1, S2) of the address multiplexer (13).

4. Circuit according to one of Claims 1 to 3, characterised in that the address register output is conducted to an input (E4) of the address multiplexer (13), and in that the address multiplexer (13) is provided with a further control input (S4), via which the address register output can be connected through to the output (13a) of the address multiplexer (13).

5. Circuit according to one of Claims 1 to 4, characterised in that an address input line (20) is provided, which is conducted from the control unit (2) to one input of the address multiplexer (13), and in that the address multiplexer (13) is provided with an additional control input (S3), via which the address input line (20) can be connected through to the output (13a) of the address multiplexer (13).

## Revendications

1. Circuit pour réaliser l'adressage cyclique d'une mémoire par l'intermédiaire d'un registre d'adresses (14), caractérisé par le fait que le registre d'adresses (14) est branché en aval d'un multiplexeur d'adresses (13), qui comporte des entrées (E1,E2) raccordées à un second registre (15) utilisé pour mémoriser une limite inférieure de la zone d'adresses, et un dispositif d'incrémentation (19), qui est raccordé, par son entrée (19a) à la sortie du registre d'adresses (14), les entrées de commande (S1,S2) du multiplexeur d'adreses (13) sont raccordées à un circuit logique (21), qui est raccordé respectivement aux sorties du registre d'adresses (14) et à un troisième registre (16) utilisé pour mémoriser une limite supérieure de la zone d'adresses, et qu'en cas d'égalité des contenus du registre d'adresses (14) et du troisième registre (16), le circuit logique (21) raccorde directement le second registre à la sortie (13a) du multiplexeur d'adresses (13) et qu'en cas d'inégalité entre lesdits contenus, le circuit logique (21) raccorde le dispositif d'incrémentation (19) à la sortie (13a) du multiplexeur d'adresses (13).

2. Circuit pour réaliser l'adressage cyclique d'une mémoire par l'intermédiaire d'un registre d'adresses (14), caractérisé par le fait que le registre d'adresses est branché en aval d'un multiplexeur d'adresses (13) qui comporte des entrées (E1,E2) qui sont raccordées à un quatrième registre utilisé pour mémoriser une limite supérieure de la zone d'adresses, et un dispositif de décrémentation (19), qui est raccordé par l'intermédiaire de son entrée (19a) à la sortie du registre d'adresses (14), que des entrées de commande (S1,S2) du multiplexeur d'adresses (13) sont raccordées à un circuit logique (21), qui est raccordé respectivement aux sorties du registre d'adresses (14) et d'un cinquième registre utilisé pour mémoriser une limite inférieure de la zone d'adresses, et qu'en cas d'égalité des contenus du registre d'adresses (14) et du cinquième registre, le circuit logique (21) raccorde directement le quatrième registre à la sortie (13a) du multiplexeur d'adresses (13), alors qu'en cas d'inégalité desdits contenus, il raccorde le dispositif de décrémentation à ladite sortie (13a).

3. Circuit suivant la revendication 1 ou 2, caractérisé par le fait que la sortie du troisième ou du cinquième registre et la sortie du registre d'adresses sont raccordées à des entrées d'un circuit OU-Exclusif (25), qui est contenu dans le circuit logique (21) et dont la sortie est raccordée aux entrées d'un circuit OU (26), dont la sortie est raccordée d'une part par un inverseur (27) à la première entrée d'un premier circuit ET (28) et d'autre part à la première entrée d'un second circuit ET (29), que les deux entrées des deux circuits ET (28,29) sont raccordées à un conducteur de commande (22) du circuit logique (21) et que les sorties des circuits ET (28, 29) sont raccordées respectivement à une entrée de commande (S1,S2) du multiplexeur d'adresses (13).

4. Circuit suivant l'une des revendications 1 à 3, caractérisé par le fait que la sortie du registre d'adresses est raccordée à une entrée (E4) du multiplexeur d'adresses (13) et que ce dernier comporte une autre entrée de commande (S4), par l'intermédiaire de laquelle la sortie du registre d'adresses peut être interconnectée à la sortie (13a) du multiplexeur d'adresses (13).

5. Circuit suivant l'une des revendications 1 à 4, caractérisé par le fait qu'il est prévu un conducteur d'entrée d'adresses (20), qui est raccordé par une unité de commande pilote (2) à une entrée du multiplexeur d'adresses (13), que le multiplexeur d'adresses (13) comporte une entrée supplémentaire de commande (S3), au moyen de laquelle le conducteur d'entrée d'adresses (20) peut être interconnecté à la sortie (13a) du multiplexeur d'adresses (13).

# FIG 1

FIG 2

FIG 3